# DEMANDE DE BREVET EUROPEEN

(11) **EP 4 415 037 A1**
(43) Date de publication de la demande: **14.08.2024**
(21) Numéro de dépôt: 24155576.2
(22) Date de dépôt: 02.02.2024
(51) Int. Cl.: H01L 23/29, H01L 23/31

(54) **FORMATION D'UN COMPOSANT ELECTRONIQUE DE PUISSANCE**

(30) Priorité: 08.02.2023 FR 2301163
(71) Demandeur: STMicroelectronics International N.V., 1228 Plan-les-Ouates, Geneva (CH)
(72) Inventeur: MORILLON, Benjamin, 37100 TOURS (FR)
(74) Mandataire: Cabinet Beaumont

(57) **Abrégé**

La présente description concerne un procédé de formation d'un composant électronique de puissance (100) dans et sur un substrat semiconducteur (13), comportant les étapes successives suivantes :
a) formation d'un sillon périphérique (15) dans le substrat semiconducteur du côté d'une première face du substrat semiconducteur ;
b) dépôt d'une couche en polysilicium dopé en oxygène (21), sur et en contact avec le fond et les parois du sillon périphérique et avec ladite première face du substrat semiconducteur ;
c) dépôt localisé d'une couche en verre (31), sur la couche en polysilicium dopé en oxygène (21), la couche en verre (31) s'étendant dans le sillon périphérique (15) et se prolongeant sur une partie de ladite première face du substrat semiconducteur ; et
d) gravure de la couche en polysilicium dopé en oxygène (21) de sorte qu'elle s'étende sur ladite première face du substrat semiconducteur au-delà de la couche en verre (31).

## Description

### Domaine technique

La présente description concerne de façon générale les composants électroniques semi-conducteurs et plus particulièrement les composants électroniques de puissance comme les thyristors et triacs.

### Technique antérieure

On connaît différentes technologies de composants de puissance et différentes techniques de fabrication de ces composants. On connaît notamment la technologie MESA qui consiste à entourer une jonction PN, formée dans toute la surface du composant, d'un sillon (aussi appelé tranchée) rempli de verre sur au moins une face du composant comme terminaison de la jonction.

Il existe un besoin d'amélioration des composants électroniques de puissance, notamment les composants électroniques de la technologie MESA, et de leurs techniques de fabrication. Plus particulièrement, il existe un besoin de stabiliser des courants de fuite et/ou d'augmentation de la tenue en tension dans ces composants.

### Résumé de l'invention

Pour cela, un mode de réalisation prévoit un procédé de formation d'un composant électronique de puissance dans et sur un substrat semiconducteur, comportant les étapes successives suivantes :
a) formation d'un sillon périphérique dans le substrat semiconducteur du côté d'une première face du substrat semiconducteur ;
b) dépôt d'une couche en polysilicium dopé en oxygène, sur et en contact avec le fond et les parois du sillon périphérique et avec ladite première face du substrat semiconducteur ;
c) dépôt localisé d'une couche en verre, sur la couche en polysilicium dopé en oxygène, la couche en verre s'étendant dans le sillon périphérique et se prolongeant sur une partie de ladite première face du substrat semiconducteur ; et
d) gravure de la couche en polysilicium dopé en oxygène de sorte qu'elle s'étende sur ladite première face du substrat semiconducteur au-delà de la couche en verre.

Selon un mode de réalisation, le procédé comporte, entre les étapes b) et c), une étape e) de dépôt d'une couche électriquement isolante sur et en contact avec la couche en polysilicium dopé en oxygène.

Selon un mode de réalisation, le procédé comporte, entre les étapes c) et d), une étape e) de dépôt d'une couche électriquement isolante sur et en contact avec la couche de verre et une partie de la couche en polysilicium dopé en oxygène non recouverte par la couche en verre.

Selon un mode de réalisation, la couche électriquement isolante est gravée, en même temps que la couche en polysilicium dopé en oxygène lors de l'étape d).

Selon un mode de réalisation, le dépôt de la couche en verre lors de l'étape c) est effectué par sérigraphie.

Selon un mode de réalisation, le sillon a une profondeur supérieure à 75 µm.

Selon un mode de réalisation, la couche en polysilicium dopé en oxygène a une épaisseur comprise entre 0,1 µm et 2 µm.

Un autre mode de réalisation prévoit un composant comportant :
- un sillon périphérique formée dans un substrat semiconducteur du côté d'une première face du substrat semiconducteur ;
- une couche en polysilicium dopé en oxygène, formée sur et en contact avec le fond et les parois du sillon périphérique et avec ladite première face du substrat semiconducteur ; et
- une couche en verre, formée sur la couche en polysilicium dopé en oxygène, la couche en verre s'étendant dans le sillon périphérique et se prolongeant sur une partie de ladite première face du substrat semiconducteur et la couche en polysilicium dopé en oxygène s'étendant sur ladite première face du substrat semiconducteur au-delà de la couche en verre.

Selon un mode de réalisation, le composant comporte une couche électriquement isolante entre la couche en polysilicium dopé en oxygène et la couche en verre, la couche électriquement isolante étant en contact, par une première face, avec la couche en polysilicium dopé en oxygène et, par une deuxième face opposée à la première face, avec la couche en verre.

Selon un mode de réalisation, le composant comporte une couche électriquement isolante, la couche en verre étant en contact, par une première face, avec la couche électriquement isolante et, par une deuxième face opposée à la première face, avec la couche en polysilicium dopé en oxygène et la couche électriquement isolante étant en contact avec une partie de la couche en polysilicium dopé en oxygène non recouverte par la couche en verre.

Selon un mode de réalisation, le sillon a une profondeur supérieure à 75 µm.

Selon un mode de réalisation, la couche en polysilicium dopé en oxygène a une épaisseur comprise entre 0,1 µm et 2 µm.

Un autre mode de réalisation prévoit un circuit de contrôle de puissance comprenant un composant électronique de puissance tel que décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D et la figure 1E représentent, par des vues en coupe, partielles et schématiques, des étapes successives d'un exemple d'un procédé de fabrication d'un composant de puissance selon un premier mode de réalisation ; et
la figure 2A, la figure 2B, la figure 2C et la figure 2D représentent, par des vues en coupe, partielles et schématiques, des étapes successives d'un exemple d'un procédé de fabrication d'un composant de puissance selon un deuxième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, seule la réalisation des sillons d'isolation périphériques du composant, et des couches de passivation formées dans ces sillons, participant à la diminution de courants de fuite et à l'augmentation de la tenue en tension du composant, a été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Les composants électroniques de puissance dits verticaux comportent généralement un substrat semiconducteur comportant au moins une jonction PN planaire horizontale entourée latéralement par un sillon périphérique s'étendant verticalement dans le substrat. Afin de limiter les fuites de courant et/ou d'augmenter la tenue en tension, les composants électroniques de puissance verticaux doivent comporter une structure de passivation recouvrant les flancs et le fond du sillon et une partie d'une face du substrat semiconducteur, à la surface du sillon. La structure de passivation peut par exemple comporter une couche en polysilicium dopé en oxygène ou SIPOS (de l'anglais "Semi-Insulating Polycrystalline Silicon"). La structure de passivation peut, en outre, comporter une couche en verre formée sur la couche en SIPOS et plus précisément formée dans le sillon et sur ladite face du substrat semiconducteur, à la surface du sillon, de sorte qu'elle recouvre entièrement la couche en SIPOS.

Dans les composants électroniques de puissance, la profondeur du sillon engendre une complexité dans la gravure de la couche en SIPOS qui est réalisée avant la formation de la couche en verre. Plus particulièrement elle engendre une complexité dans la formation de la résine de masquage à travers de laquelle la couche en SIPOS est gravée, notamment sa structuration par photolithographie. En effet, le dépôt de la résine de masquage n'est pas uniforme et une quantité importante de résine doit être déposée afin que le sommet du sillon soit recouvert par la résine. Dans certains cas, l'épaisseur de résine sur la face supérieure du substrat est telle qu'une unique étape de photolithographie ne permet pas de l'insoler localement dans toute son épaisseur. Par exemple, dans le cas de composants électroniques de puissance à très haute tenue en tension (par exemple supérieure ou égale à 1200 V), la profondeur du sillon peut être supérieure à une centaine de micromètres et l'épaisseur de la résine de masquage peut atteindre plusieurs dizaines de micromètres. Ainsi, plusieurs cycles de dépôt puis insolation de la résine peuvent être nécessaires pour obtenir l'épaisseur souhaitée. Il en résulte une complexité accrue et une augmentation du coût de la fabrication des composants.

Les composant électronique de puissance décrits peuvent par exemple, être utilisés dans divers circuit de contrôle, de conversion ou d'adaptation de puissance, par exemple dans des équipements industriels, des dispositifs d'affichage ou d'éclairage, des équipements de télécommunications, des équipements électroménagers, des dispositifs automobiles, etc.

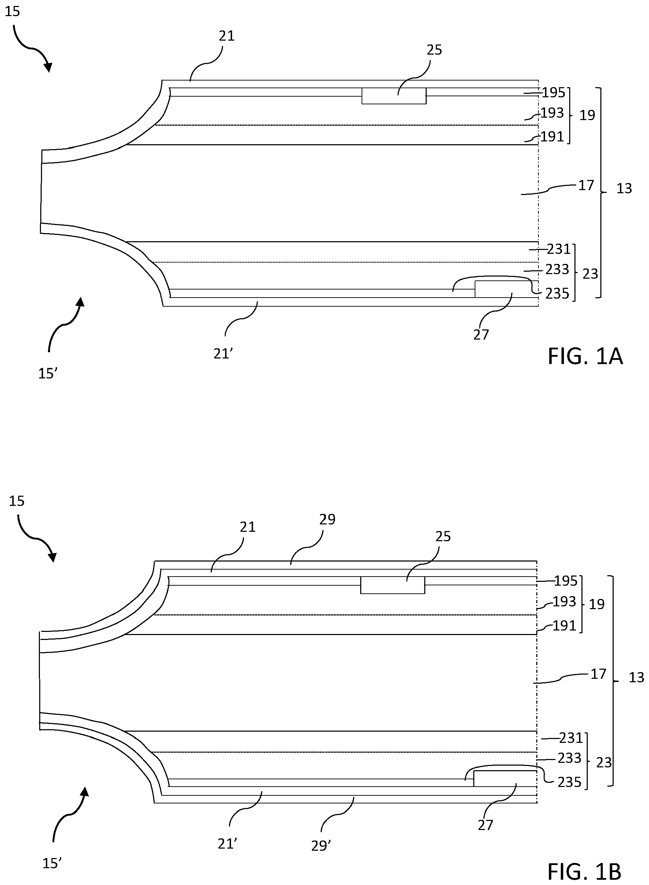

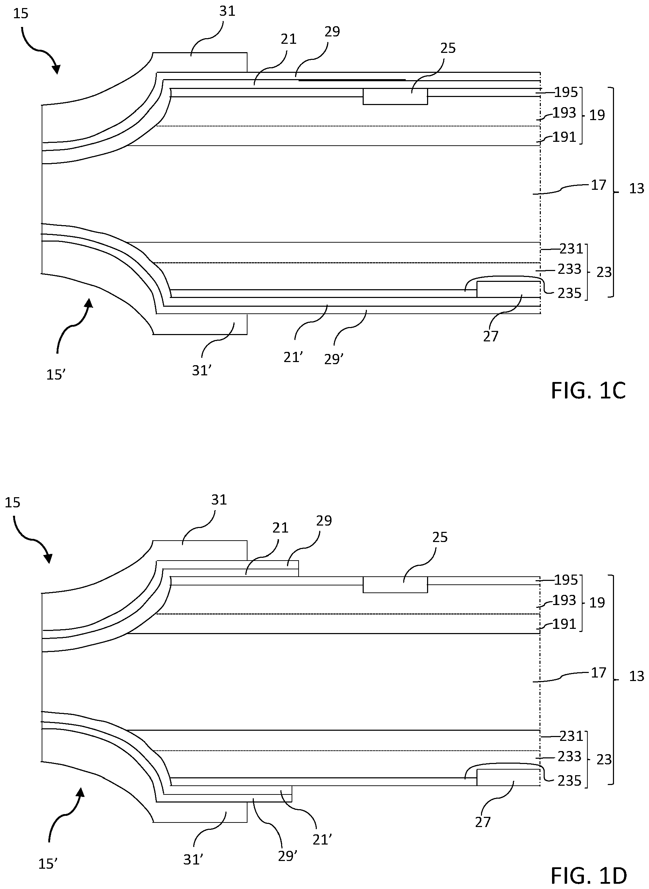

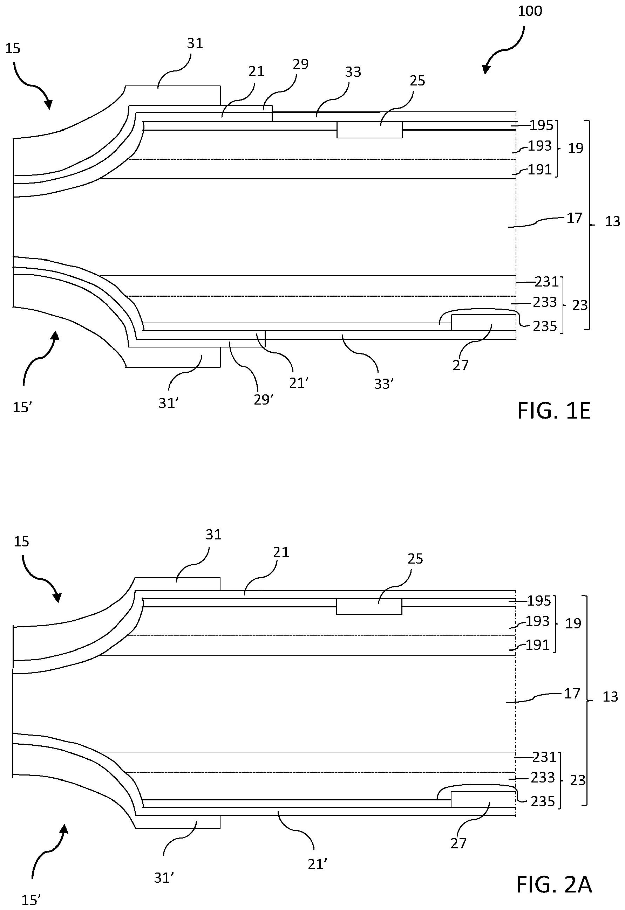

La figure 1A, la figure 1B, la figure 1C, la figure 1D et la figure 1E représentent, par des vues en coupe, partielles et schématiques, des étapes successives d'un exemple d'un procédé de fabrication d'un composant de puissance selon un premier mode de réalisation. Les figures 1A à 1E illustrent plus particulièrement un exemple d'un procédé de formation d'une structure périphérique de passivation d'un composant de puissance selon le premier mode de réalisation. On notera que sur les figures, la réalisation d'un unique composant est représentée. En pratique, une pluralité de composants peuvent être formés simultanément dans et sur un même substrat semiconducteur, le substrat étant ensuite découpé en puces individuelles comportant chacune un unique composant électronique de puissance.

La figure 1A représente une structure de départ comportant un substrat 13 semiconducteur dans lequel est formé, du côté de sa face supérieure, un sillon périphérique 15 entourant latéralement une jonction PN planaire horizontale du composant. En figure 1A seulement une partie de la structure de départ a été représentée. En pratique la structure s'étend au-delà du bord droit représenté en pointillés en figure 1A, le sillon périphérique 15 entourant la structure.

Le composant a par exemple, en vue de dessus, une forme générale carrée ou rectangulaire, par exemple à coins arrondis, ou circulaire. Le substrat 13 est, par exemple, en silicium.

A titre d'exemple, le substrat 13 comprend une partie centrale 17, par exemple dopée d'un premier type de conductivité, par exemple dopée de type N. A titre d'exemple, le substrat 13 comprend, de plus, une partie supérieure 19, par exemple dopée d'un deuxième type de conductivité différent du premier type de conductivité, par exemple dopée de type P. A titre d'exemple, la partie supérieure 19 est en contact, par sa face inférieure avec la face supérieure de la partie centrale 17 du substrat 13.

La partie supérieure 19 du substrat 13 comprend par exemple un gradient de dopage croissant à partir de sa face inférieure. De plus, la partie supérieure 19 du substrat 13 comprend par exemple plusieurs éléments dopants différents.

A titre d'exemple, la partie supérieure 19 du substrat 13 comprend une première portion 191, en contact, par sa face inférieure avec la face supérieure de la partie 17 du substrat 13. La première portion 191 est par exemple dopée en atomes d'aluminium.

De plus, la partie supérieure 19 du substrat 13 comprend par exemple une deuxième portion 193, en contact, par sa face inférieure avec la face supérieure de la portion 191. La deuxième portion 193 est par exemple dopée en atomes de gallium.

A titre d'exemple, la partie supérieure 19 du substrat 13 comprend, en outre, une troisième portion 195, en contact, par sa face inférieure avec la face supérieure de la portion 193. La troisième portion 195 est par exemple dopée en atomes, de gallium.

A titre d'exemple, le sillon 15 formé sur la face supérieure de la structure de départ s'étend à partir de la face supérieure de la partie supérieure 19 du substrat 13 dans le substrat 13 et débouche dans la première partie 17 du substrat 13. Le sillon s'étend ainsi, par exemple, à travers les portions 195, 193 et 191. Ainsi, le sillon 15 traverse la jonction PN formée par le plan horizontal d'interface entre les parties supérieure 19 et centrale 17.

La profondeur du sillon 15 à partir de la face supérieure du substrat 13 est par exemple supérieure à 30 µm, par exemple supérieure 75 µm, par exemple supérieure à 105 µm, par exemple comprise entre 105 µm et 150 µm.

La structure de la figure 1A comporte, de plus, une couche 21 en polysilicium dopé en oxygène ou SIPOS (de l'anglais "Semi-Insulating Polycrystalline Silicon"), s'étendant sur les parois des sillons 15 et sur et en contact avec la face supérieure du substrat 13, à la surface des sillons 15. A titre d'exemple, la couche en SIPOS 21 a un pourcentage en oxygène compris entre 10 % et 50 %, par exemple compris entre 20 % et 40 %.

La couche en SIPOS 21 est, par exemple déposée à la surface du substrat 13 et dans les sillons 15 par un procédé de dépôt chimique en phase vapeur, par exemple par un procédé de dépôt chimique en phase vapeur à basse pression ou LPCVD (de l'anglais " Low pressure chemical vapor deposition"). A titre d'exemple, la couche en SIPOS 21 a une épaisseur comprise entre 0,1 µm et 2 µm, par exemple comprise entre 0,1 µm et 1 µm, par exemple de l'ordre de 0,5 µm.

La structure de départ illustrée en figure 1A est par exemple symétrique horizontalement. Le substrat 13 comporte par exemple une partie inférieure 23 comportant des portions 231, 233 et 235 par exemple respectivement similaires aux portions 191, 193 et 195 de la partie supérieure 19. La structure comporte par exemple un sillon 15' formé à partir de la face inférieure du substrat 13. A titre d'exemple, le sillon 15' s'étend dans la partie inférieure 23 et débouche dans la partie centrale 17 du substrat 13. La structure de départ comporte par exemple une autre couche en SIPOS 21' s'étendant sur et en contact avec la face inférieure du substrat 13 et sur les parois du sillon 15' formé à partir de la face inférieure du substrat 13. Ainsi, le sillon 15' traverse la jonction PN formée par le plan horizontal d'interface entre les parties inférieure 23 et centrale 17 du substrat.

La structure de départ comporte de plus une zone dopée localisée 25 du coté de la face supérieure du substrat 13, affleurant cette même face. La structure peut en outre comporter une zone dopée localisée 27 du coté de la face inférieure du substrat 13, affleurant cette même face.

A titre d'exemple, les couches 17, 19 et 23 s'étendent chacune sur toute la surface du substrat. Les zones 25 et 27 sont quant à elles localisées respectivement sur une partie seulement de la surface du substrat.

Les zones 25 et 27 sont, par exemple, dopées du premier type de conductivité, par exemple du type N. A titre d'exemple, les zones 25 et 27 sont plus fortement dopées que la partie centrale 17 du substrat 13 et que les portions 195 et 235 du substrat 13. A titre d'exemple les zones 25 et 27 sont dopées d'atomes de phosphore.

La structure de départ est ainsi constituée d'un premier empilement vertical de quatre régions 19, 17, 23, et 27 alternativement dopées P et N, et d'un deuxième empilement vertical de quatre régions 25, 19, 17 et 23 alternativement dopées N et P, qui définissent un triac. Les modes de réalisation décrits ne se limitent pas à cet exemple de composant. A titre d'exemple, la région 27 peut être omise dans le cas d'une structure de type thyristor. Plus généralement, les modes de réalisation décrits peuvent être appliqués à tout composant électronique de puissance dit vertical, comportant une jonction PN horizontal et une structure de passivation formée dans un sillon d'isolation périphérique traversant verticalement la jonction PN.

La figure 1B illustre une structure obtenue à l'issue d'une étape de formation d'une couche électriquement isolante 29 sur la face supérieure de la structure illustrée en figure 1A. Dans cet exemple, une couche électriquement isolante 29' est en outre formée sur la face inférieure de la structure.

Plus particulièrement, lors de cette étape, la couche 29 est formée pleine plaque, c'est-à-dire qu'elle est formée sur l'ensemble de la face supérieure de la structure illustrée en figure 1A. Lors de cette étape, la couche 29 est formée en contact avec la couche en SIPOS 21. La couche 29 recouvre par exemple la face supérieure de la couche 21 située sur les flancs et dans le fond du sillon 15 et s'étendant à la surface du sillon 15.

Similairement, la couche 29' est formée pleine plaque, c'est-à-dire qu'elle est formée sur l'ensemble de la face inférieure de la structure illustrée en figure 1A. Lors de cette étape, la couche 29' est formée en contact avec la couche en SIPOS 21'. La couche 29' recouvre par exemple la face inférieure de la couche 21' située sur les flancs et dans le fond du sillon 15' et s'étendant à la surface du sillon 15'.

A titre d'exemple, les couches 29 et 29' sont en verre non dopé, par exemple en verre de silicium non dopé (USG, de l'anglais "Undoped Silicon Glass") ou en verre phosphosilicate non dopé (PSG, de l'anglais " PhosphoSilicate Glass"). Les couches 29 et 29' sont par exemple déposées par un procédé de dépôt chimique en phase vapeur, par exemple par un procédé de dépôt LPCVD. A titre d'exemple les couches 29 et 29' ont une épaisseur comprise entre 0,1 µm et 1,5 µm, par exemple comprise entre 0,5 µm et 1 µm.

La figure 1C illustre une structure obtenue à l'issue d'une étape de formation d'une couche en verre 31 sur la face supérieure de la structure illustrée en figure 1B. Dans cet exemple, une couche en verre 31' est en outre formée sur la face inférieure de la structure.

Plus particulièrement, lors de cette étape, la couche 31 est formée localement à la surface de la couche 29 et, par exemple, en contact avec celle-ci. La couche 31 recouvre ainsi la couche 29 située dans le fond et sur les flancs du sillon 15 et à la surface du sillon 15 sans s'étendre sur toute la surface de la couche 29 à la surface de la sillon 15.

Similairement, lors de cette étape, la couche 31' est formée localement à la surface de la couche 29' et, par exemple, en contact avec celle-ci. La couche 31' recouvre ainsi la couche 29' située dans le fond et sur les flancs du sillon 15' et à la surface du sillon 15' sans s'étendre sur toute la surface de la couche 29' à la surface du sillon 15'.

Les couches 31 et 31' sont déposées par un procédé de dépôt localisé, par exemple par sérigraphie. Cette étape consiste par exemple au dépôt d'une pâte de verre à travers un masque situé à la surface de la couche 29 ou de la couche 29'. A titre d'exemple, après ce dépôt, les couches 31 et 31' subissent une ou des étapes de recuit. L'étape de recuit peut par exemple comprendre une étape de pyrolyse à une température comprise entre 300 °C et 700 °C, par exemple de l'ordre de 500 °C. L'étape de recuit peut en outre comprendre une étape de frittage à une température comprise entre 500 °C et 1000 °C, par exemple de l'ordre de 800 °C.

A titre d'exemple, les couches 31 et 31' ont une épaisseur non constante sur l'ensemble de leurs surfaces. Elle est par exemple plus importante au fond des sillons 15 et 15' (c'est-à-dire dans les sillons de la plaquette entre les composants) qu'en leur sommet et à la surface des sillons 15 et 15'.

L'épaisseur des couches 31 et 31' à la surface du substrat 13 en périphérie des sillons 15 et 15' est par exemple comprise entre 10 µm et 40 µm, par exemple comprise entre 20 µm et 30 µm.

L'épaisseur des couches 31 et 31' dans le fond des sillons 15 et 15' est par exemple comprise entre 20 µm et 70 µm, par exemple comprise entre 40 µm et 50 µm.

La figure 1D illustre une structure obtenue à l'issue d'une étape de retrait localisé des couches 21 et 29 et des couches 21' et 29' de la structure illustrée en figure 1C.

Lors de cette étape, on vient par exemple dans un premier temps former par photolithographie une couche de masquage (non représentée) en une résine photosensible sur la face supérieure de la structure illustrée en figure 1C.

A titre d'exemple, la résine photosensible de la couche de masquage est déposée par centrifugation (spin-coating), exposée aux UV puis développée dans un solvant. A titre d'exemple, la couche de masquage recouvre toute la surface de la couche en verre 31 . La couche de masquage se prolonge en outre latéralement au delà la couche en verre 31, et recouvre ainsi une partie des couches 21 et 29 au voisinage de la couche en verre 31. La couche de masquage ne recouvre toutefois pas les couches 21 et 29 en vis-à-vis d'une partie centrale du composant.

Lors de cette étape, et dans un second temps, on vient graver les couches 21 et 29 à travers la couche de masquage. A titre d'exemple la gravure des couches 21 et 29 est une gravure humide.

Similairement, on vient par exemple également lors de cette étape former par photolithographie une couche de masquage (non représentée) en une résine photosensible sur la face inférieure de la structure illustrée en figure 1C puis graver les couches 21' et 29' à travers la couche de masquage.

A l'issue de cette étape, les couches 21 et 29 s'étendent, par exemple, dans le fond et sur les flancs des sillons 15 et à la surface du sillon 15 sur une partie de la face supérieure du substrat 13. A titre d'exemple, les couches 21 et 29 s'étendent sur la face supérieure du substrat 13 au-delà de la couche en verre 31, c'est-à-dire que les couches 21 et 29 s'étendent sur le substrat 13 dans l'ensemble du vis-à-vis de la couche en verre 31 et se prolonge sur une partie du substrat 13 en dehors du vis-à-vis de la couche en verre 31. A titre d'exemple, à l'issue de cette étape, les couches 21 et 29 ne recouvrent pas la zone 25.

Similairement, les couches 21' et 29' s'étendent, par exemple, dans le fond et sur les flancs des sillons 15' et à la surface du sillon 15' sur une partie de la face inférieure du substrat 13. A titre d'exemple, les couches 21' et 29' s'étendent sur la face inférieure du substrat 13 au delà de la couche en verre 31', c'est-à-dire que les couches 21' et 29' s'étendent sur le substrat 13 dans l'ensemble du vis-à-vis de la couche en verre 31' et se prolonge sur une partie du substrat 13 en dehors du vis-à-vis de la couche en verre 31'. A titre d'exemple, à l'issue de cette étape, les couches 21' et 29' ne recouvrent pas la zone 27.

La figure 1E illustre une structure obtenue à l'issue d'une étape de formation de couches électriquement conductrices 33 et 33' respectivement sur les faces supérieure et inférieure de la structure illustrée en figure 1D.

Plus particulièrement, lors de cette étape, on vient par exemple former une couche électriquement conductrice 33 dans le prolongement des couches 21 et 29 à la surface du substrat 13. A titre d'exemple, la couche 33 est formée en contact avec une partie de la face supérieure du substrat 13 non recouverte par les couches 21 et 29. A titre d'exemple, la couche 33 s'étend à partir des couches 21 et 29 et est, par exemple, en contact par son flanc avec le flanc des couches 21 et 29.

Similairement, lors de cette étape, on vient également par exemple former une couche électriquement conductrice 33' dans le prolongement des couches 21' et 29' à la surface du substrat 13. A titre d'exemple, la couche 33' est formée en contact avec une partie de la face inférieure du substrat 13 non recouverte par les couches 21' et 29'. A titre d'exemple, la couche 33' s'étend à partir des couches 21' et 29' et est, par exemple, en contact par son flanc avec le flanc des couches 21' et 29'.

A titre d'exemple les couches 33 et 33' sont en un matériau métallique, par exemple en or et/ou en nickel. A titre d'exemple, les couches 33 et 33' sont formées par dépôt par voie humide, par exemple par un dépôt chimique dit sans électrodes (en anglais "electroless").

Lors de cette étape, le dépôt est formé uniquement sur les parties conductrices de la structure et n'est pas formé sur les parties isolantes de la structure. Les couches 33 et 33' sont ainsi formées sélectivement en contact avec les parties semiconductrices libres de la structure illustrée en figure 1D. Les couches 33 et 33' sont alors formées respectivement en contact avec la face supérieure et la face inférieure du substrat 13. A titre d'exemple, les couches 29 et 29' permettent, lors de cette étape, de protéger respectivement la face supérieure de la couche 21 et la face inférieure de la couche 21' du dépôt des couches 33 et 33'. Les couches 29 et 29' permettent notamment de protéger respectivement les couches 21 et 21' du dépôt des couches 33 et 33'. En effet, en l'absence des couches 29 et 29', les couches 33 et 33' auraient tendance à se former en outre sur une partie des couches 21 et 21' qui sont semi-isolantes.

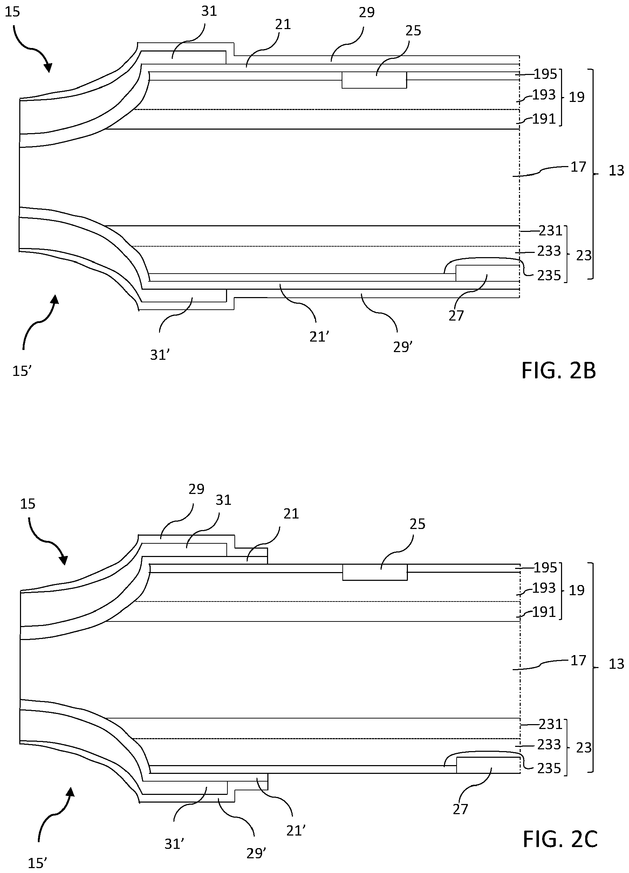

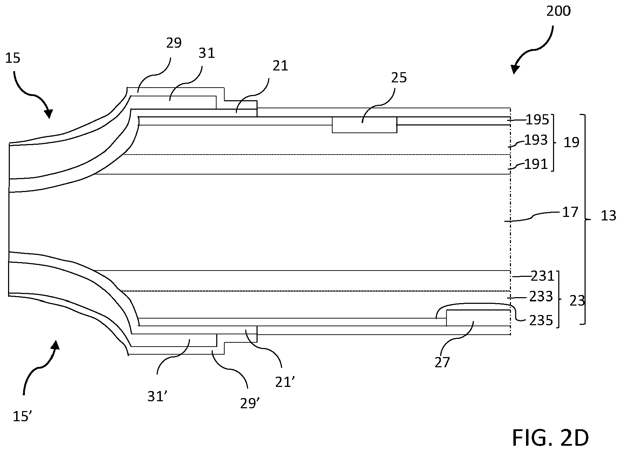

La figure 2A, la figure 2B, la figure 2C et la figure 2D représentent, par des vues en coupe, partielles et schématiques, des étapes successives d'un exemple d'un procédé de fabrication d'un composant de puissance selon un deuxième mode de réalisation.

Plus particulièrement, les figures 2A à 2D illustrent le procédé de fabrication d'un composant de puissance selon un deuxième mode de réalisation. Le procédé des figures 2A à 2D diffère du procédé des figures 1A à 1E essentiellement en ce que, dans le procédé des figures 2A à 2D, la couche électriquement isolante 29 est formée après la couche en verre 31.

La figure 2A illustre une structure obtenue à l'issue d'une étape de formation des couches en verre 31 et 31' respectivement sur les faces supérieure et inférieure de la structure illustrée en figure 1A.

L'étape de formation des couches en verre 31 et 31' illustrée en figure 2A est par exemple similaire à l'étape de formation des couches en verre 31 et 31' illustrée en figure 1C à la différence près que, en figure 2A, les couches en verre 31 et 31' sont respectivement formées sur et en contact avec les couches en SIPOS 21 et 21'.

Lors de cette étape, la couche 31 est ainsi formée localement à la surface de la couche 21 et par exemple en contact avec celle-ci. La couche 31 recouvre ainsi la couche 21 située dans le fond et sur les flancs du sillon 15 et à la surface du sillon 15 sans s'étendre sur toute la surface de la couche 21 à la surface du sillon 15.

Similairement, lors de cette étape, la couche 31' est formée localement à la surface de la couche 21' et par exemple en contact avec celle-ci. La couche 31' recouvre ainsi la couche 21' située dans le fond et sur les flancs du sillon 15' et à la surface du sillon 15' sans s'étendre sur toute la surface de la couche 21' à la surface du sillon 15'.

La figure 2B illustre une structure obtenue à l'issue d'une étape de formation des couches électriquement isolantes 29 et 29' respectivement sur les faces supérieure et inférieure de la structure illustrée en figure 2A.

L'étape de formation des couches électriquement isolantes 29 et 29' illustrée en figure 2B est par exemple similaire à l'étape de formation des couches électriquement isolantes 29 et 29' illustrée en figure 1B à la différence près que, en figure 2B, la couche électriquement isolante 29 est formée sur et en contact avec la couche en verre 31 et avec la partie de la couche en SIPOS 21 non recouverte par la couche en verre 31. En outre, l'étape de formation des couches électriquement isolantes 29 et 29' illustrée en figure 2B diffère de l'étape de formation des couches électriquement isolantes 29 et 29' illustrée en figure 1B en ce que, en figure 2B, la couche électriquement isolante 29' est formée sur et en contact avec la couche en verre 31' et avec la partie de la couche en SIPOS 21' non recouverte par la couche en verre 31'.

La couche 29 recouvre ainsi la face supérieure de la couche en verre 31 située sur les flancs et dans le fond du sillon 15 et s'étendant à la surface du sillon 15 et recouvre en outre la partie de la face supérieure de la couche 21 à la surface du sillon 15 non recouverte par la couche 31. A titre d'exemple, la couche 29 recouvre le flanc de la couche en verre 31 à la surface du sillon 15. A titre d'exemple, à l'issue de cette étape, la couche en verre 31 est en contact, par sa face inférieure, avec la face supérieure de la couche en SIPOS 21 et, par sa face supérieure, avec la face inférieure de la couche 29.

Similairement, la couche 29' recouvre ainsi la face inférieure de la couche en verre 31' située sur les flancs et dans le fond du sillon 15' et s'étendant à la surface du sillon 15' et recouvre en outre la partie de la face inférieure de la couche 21' à la surface du sillon 15' non recouverte par la couche en verre 31'. A titre d'exemple, la couche 29' recouvre le flanc de la couche en verre 31' à la surface du sillon 31'. A titre d'exemple, à l'issue de cette étape, la couche en verre 31' est en contact, par sa face supérieure, avec la face inférieure de la couche en SIPOS 21' et, par sa face inférieure, avec la face supérieure de la couche 29'.

La figure 2C illustre une structure obtenue à l'issue d'une étape de structuration ou retrait localisé des couches 21 et 29 et des couches 21' et 29' de la structure illustrée en figure 2B.

L'étape de structuration des couches 21 et 29 et des couches 21' et 29' illustrée en figure 2C est par exemple similaire à l'étape de structuration des couches 21 et 29 et des couches 21' et 29' illustrée en figure 1D à la différence près que, en figure 2C, les couche de masquage permettant de graver les couches 21 et 29 et les couches 21' et 29' sont formées respectivement sur et en contact avec la face supérieure de la couche 29 et sur et en contact avec la face inférieure de la couche 29'.

La figure 2D illustre une structure obtenue à l'issue d'une étape de formation de couches électriquement conductrices 33 et 33' respectivement sur les faces supérieure et inférieure de la structure illustrée en figure 2C.

L'étape de formation des couches 33 et 33' illustrée en figure 2D est par exemple identique à l'étape de formation des couches 33 et 33' illustrée en figure 1E.

Un avantage des modes de réalisation décrits est qu'ils permettent de s'affranchir d'une ou plusieurs étapes de photolithographie et donc de diminuer les coûts de fabrication du composant électronique considéré. En particulier, le dépôt localisé des couches de verre 31, 31', permet de s'affranchir d'une étape de gravure localisée desdites couches de verre.

En outre, l'étape de retrait localisé des couches de passivation 21, 29 et, le cas échéant, 21', 29', est mise en oeuvre après le dépôt du verre 31, 31' dans les sillons 15, 15'. Ainsi, lors de cette étape, les sillons 15, 15' sont au moins partiellement comblées par le verre 31, 31'. Il en résulte qu'une épaisseur réduite de résine photosensible de masquage peut être utilisée pour l'étape de gravure localisée des couches 21, 29 et 21', 29'. Ceci permet de simplifier cette étape de gravure localisée et d'en réduire le coût.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisations décrits ne se limitent pas aux exemples de dimensions et de matériaux mentionnés ci-dessus.

De plus, bien que les modes de réalisation aient été décrits pour un triac, la présente invention elle peut s'appliquer à tous dispositifs comportant un sillon périphérique mésa passivée avec une couche de verre et une couche en SIPOS.

Enfin, la mise en oeuvre pratique des modes de réalisation et variantes décrits est à la portée de la personne du métier à partir des indications fonctionnelles données ci-dessus.

## Revendications

1. Procédé de formation d'un composant électronique de puissance (100 ; 200) dans et sur un substrat semiconducteur (13), comportant les étapes successives suivantes :
a) formation d'un sillon périphérique (15, 15') dans le substrat semiconducteur (13) du côté d'une première face du substrat semiconducteur (13) ;
b) dépôt d'une couche en polysilicium dopé en oxygène (21, 21'), sur et en contact avec le fond et les parois du sillon périphérique (15, 15') et avec ladite première face du substrat semiconducteur (13) ;
c) dépôt localisé d'une couche en verre (31, 31'), sur la couche en polysilicium dopé en oxygène (21, 21'), la couche en verre (31, 31') s'étendant dans le sillon périphérique (15, 15') et se prolongeant sur une partie de ladite première face du substrat semiconducteur (13) ; et
d) gravure de la couche en polysilicium dopé en oxygène (21, 21') de sorte qu'elle s'étende sur ladite première face du substrat semiconducteur (13) au-delà de la couche en verre (31, 31').

2. Procédé de formation d'un composant électronique de puissance selon la revendication 1, comportant, entre les étapes b) et c), une étape e) de dépôt d'une couche électriquement isolante (29, 29') sur et en contact avec la couche en polysilicium dopé en oxygène (21, 21').

3. Procédé de formation d'un composant électronique de puissance selon la revendication 1, comportant, entre les étapes c) et d), une étape e) de dépôt d'une couche électriquement isolante (29, 29') sur et en contact avec la couche de verre (31, 31') et une partie de la couche en polysilicium dopé en oxygène (21, 21') non recouverte par la couche en verre (31, 31').

4. Procédé de formation d'un composant électronique de puissance selon la revendication 2 ou 3, dans lequel la couche électriquement isolante (29, 29') est gravée, en même temps que la couche en polysilicium dopé en oxygène (21, 21') lors de l'étape d).

5. Procédé de formation d'un composant électronique de puissance selon l'une quelconque des revendications 1 à 4, dans lequel, le dépôt de la couche en verre (31, 31') lors de l'étape c) est effectué par sérigraphie.

6. Procédé de formation d'un composant électronique de puissance selon l'une quelconque des revendications 1 à 5, dans lequel le sillon (15, 15') a une profondeur supérieure à 75 µm.

7. Procédé de formation d'un composant électronique de puissance selon l'une quelconque des revendications 1 à 6, dans lequel la couche en polysilicium dopé en oxygène (21, 21') a une épaisseur comprise entre 0,1 µm et 2 µm.

8. Composant électronique de puissance (100 ; 200), comportant :
- un sillon périphérique (15, 15') formée dans un substrat semiconducteur (13) du côté d'une première face du substrat semiconducteur (13) ;
- une couche en polysilicium dopé en oxygène (21, 21'), formée sur et en contact avec le fond et les parois du sillon périphérique (15, 15') et avec ladite première face du substrat semiconducteur (13) ; et
- une couche en verre (31, 31'), formée sur la couche en polysilicium dopé en oxygène (21, 21'), la couche en verre (31, 31') s'étendant dans le sillon périphérique (15, 15') et se prolongeant sur une partie de ladite première face du substrat semiconducteur (13) et la couche en polysilicium dopé en oxygène (31, 31') s'étendant sur ladite première face du substrat semiconducteur (13) au-delà de la couche en verre.

9. Composant électronique de puissance (100 ; 200) selon la revendication 8, comportant une couche électriquement isolante (29, 29') entre la couche en polysilicium dopé en oxygène (21, 21') et la couche en verre (31, 31'), la couche électriquement isolante (29, 29') étant en contact, par une première face, avec la couche en polysilicium dopé en oxygène (21, 21') et, par une deuxième face opposée à la première face, avec la couche en verre (31, 31').

10. Composant électronique de puissance (100 ; 200) selon la revendication 8, comportant une couche électriquement isolante (29, 29'), la couche en verre étant en contact, par une première face, avec la couche électriquement isolante (29, 29') et, par une deuxième face opposée à la première face, avec la couche en polysilicium dopé en oxygène (21, 21') et la couche électriquement isolante (29, 29') étant en contact avec une partie de la couche en polysilicium dopé en oxygène (21, 21') non recouverte par la couche en verre (31, 31').

11. Composant électronique de puissance (100 ; 200) selon l'une quelconque des revendications 8 à 10, dans lequel le sillon (15, 15') a une profondeur supérieure à 75 µm.

12. Composant électronique de puissance (100 ; 200) selon l'une quelconque des revendications 8 à 11, dans lequel la couche en polysilicium dopé en oxygène (21, 21') a une épaisseur comprise entre 0,1 µm et 2 µm.

13. Circuit de contrôle de puissance comprenant un composant électronique de puissance selon l'une quelconque des revendications 8 à 12.
